Europäisches Patentamt

European Patent Office

Office européen des brevets

(11) Publication number: **0 504 983 A1**

# EUROPEAN PATENT APPLICATION

(21) Application number: **92200696.0**

(22) Date of filing: **11.03.92**

(51) Int. Cl.5: **G05F 3/24**, H03F 1/30

(30) Priority: **20.03.91 EP 91200620**

(43) Date of publication of application:
**23.09.92 Bulletin 92/39**

(84) Designated Contracting States:
**DE FR GB IT**

(71) Applicant: **N.V. Philips' Gloeilampenfabrieken**
**Groenewoudseweg 1**
**NL-5621 BA Eindhoven(NL)**

(72) Inventor: **Bult, Klaas**
**c/o INT. OCTROOIBUREAU B.V., Prof.**
**Holstlaan 6**
**NL-5656 AA Eindhoven(NL)**
Inventor: **Geelen, Godefridus Johannes**
**Gertrudis Maria**
**c/o INT. OCTROOIBUREAU B.V., Prof.**
**Holstlaan 6**
**NL-5656 AA Eindhoven(NL)**
Inventor: **Schouwenaars, Henrikus Johannes**
**c/o INT. OCTROOIBUREAU B.V., Prof.**
**Holstlaan 6**
**NL-5656 AA Eindhoven(NL)**
Inventor: **Groeneveld, Dirk Wouter Johannes**
**c/o INT. OCTROOIBUREAU B.V., Prof.**
**Holstlaan 6**
**NL-5656 AA Eindhoven(NL)**

(74) Representative: **Faessen, Louis Marie**
**Hubertus et al**
**INTERNATIONAAL OCTROOIBUREAU B.V.**
**Prof. Holstlaan 6**
**NL-5656 AA Eindhoven(NL)**

(54) Reference circuit for supplying a reference current with a predetermined temperature coefficient.

(57) A reference circuit for supplying a reference current with a predetermined temperature coefficient comprises first means (M1) for generating a first reference current with a negative temperature coefficient, which first means comprise a first non-linear current having at least one unidirectional unipolar element (D11) and a first further current mirror, second means (M2) for generating a second reference current with a positive temperature coefficient, which second means comprise a second non-linear current mirror having at least a first unidirectional bipolar element (D21) and second unidirectional bipolar element (D22), and a second further current mirror, and third means (M3) for generating the reference current with the predetermined temperature coefficient on the basis of the first and the second reference current.

The invention relates to a reference circuit for supplying a reference current with a predetermined temperature coefficient, which circuit comprises first means for generating a first reference current with a negative temperature coefficient, second means for generating a second reference current with a positive temperature coefficient, and third means for generating the reference current with the predetermined temperature coefficient on the basis of the first and the second reference current.

Such a reference circuit can be used *inter alia* in integrated semiconductor circuits for supplying a reference current to parts of such a semiconductor circuit, such as for example amplifier arrangements.

Such a reference circuit is known from Patent Specification US-P 4,636,742, which has been published in the United States of America and which describes a reference circuit for supplying a reference current for a differential amplifier. For generating the predetermined reference current the reference circuit described therein comprises some circuit sections corresponding to the first, the second and the third means and formed by means of some transistors and resistors.

A disadvantage of the reference circuit described in said Patent Specification is that owing to the fabrication process used the relevant resistors exhibit a degree of spread in resistance values, which degree of spread in resistance values results in an undesired degree of spread of the predetermined temperature coefficient.

It is an object of the invention to provide a reference circuit for generating a reference current with a predetermined temeperature coefficient, which in comparison with the reference circuit described in said Patent Specification exhibits a reduced degree of spread of the specific temperature coefficient.

A reference circuit in accordance with the invention is characterised in that the first means include a first non-linear current mirror comprising at least a first unipolar input transistor having a gate, having a drain coupled to the gate of the first unipolar input transistor, and having a source, a first unipolar output transistor having a gate coupled to the gate of the first unipolar input transistor, having a drain, and having a source coupled to a first supply terminal, and a unidirectional unipolar element coupled between the source of the first unipolar input transistor and the first supply terminal, and a first further current mirror having at least a first input terminal coupled to the drain of the first unipolar output transistor, having a first output terminal coupled to the drain of the first unipolar input transistor, and having a first emitter terminal coupled to a second supply terminal, in that the second means include a second non-linear currrent mirror comprising at least a second unipolar input transistor having a gate, having a drain coupled to the gate of the second unipolar input transistor, and having a source, a second unipolar output transistor having a gate coupled to the gate of the input second unipolar transistor, having a drain, and having a source, a first unidirectional bipolar element coupled between the source of the second unipolar input transistor and a third supply terminal, and a second unidirectional bipolar element coupled between the source of the second unipolar output transistor and the third supply terminal, and a second further current mirror comprising at least a second input terminal coupled to the drain of the second unipolar output transistor, a second output terminal coupled to the drain of the second unipolar input transistor, and a second emitter terminal coupled to a fourth supply terminal, and in that the third means have a third input terminal coupled to the first input terminal, a fourth input terminal coupled to the second input terminal, and a reference terminal for supplying the reference current with the predetermined temperature coefficient. In the reference circuit in accordance with the invention the reference currents having the negative and the positive temperature coefficients are generated by means of the unidirectional unipolar element and the unidirectional bipolar elements respectively, which elements, in contradistinction to said resistors, can be implemented with a high accuracy. Consequently, the reference current supplied by the reference circuit in accordance with the invention exhibits a reduced degree of spread of the specific temperature coefficient.

It is to be noted that the first means are known from the published Netherlands Patent Application NL-A 8001558, which has been laid open to public inspection, but that it is not known from said Patent Application to supply the reference current with a specific temperature coefficient which can have *inter alia* a positive value.

An embodiment of a reference circuit in accordance with the invention may be characterised in that the third means further include a third input transistor having a gate coupled to the third input terminal, having a drain coupled to the reference terminal, and having a source coupled to the second supply terminal, and a fourth input transistor having a gate coupled to the fourth input terminal, having a drain coupled to the reference terminal, and having a source coupled to the fourth supply terminal. In the third means constructed in accordance with this embodiment the third and the fourth input transistor form part of the first and the second further current mirror respectively. Consequently, the two input transiustors carry a first and a second current respectively, which currents are related to the reference currents generated by the first and the second means and which currents can be combined simply to form the reference current flowing *via* the reference terminal.

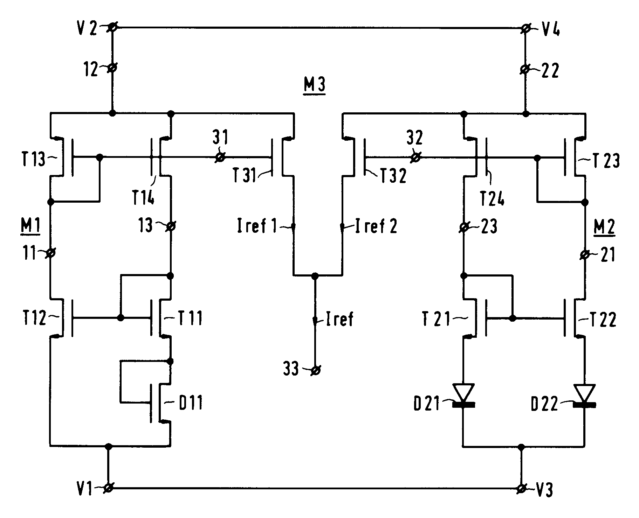

The above and further (more detailed) features of the invention will be described and explained with reference to the accompanying Figure, which

Figure shows an embodiment of a reference circuit in accordance with the invention.

The accompanying Figure shows an enbodiment of a reference circuit in accordance with the invention. The reference circuit shown comprises first means M1 for generating a first reference current Iref1 with a negative temperature coefficient, which first means M1 comprise a first non-linear current mirror (T11, T12, D11) and a first further current mirror (T13, T14), second means M2 for generating a second reference current Iref2 with a positive temperature coefficient, which second means M2 comprise a second non-linear current mirror (T21, T22, D22) and a second further current mirror (T23, T24), and third means M3 for generating the reference current Iref with the specific temperature coefficient on the basis of the first reference current Iref1 and the second reference current Iref2. The first non-linear current mirror (T11, T12, D11) comprises a first unipolar input transistor T11 having a gate, having a drain coupled to the gate of the input transistor T11, and having a source, a first unipolar output transistor T12 having a gate coupled to the gate of the input transistor T11, having a drain, and having a source coupled to the first supply terminal V1, and a unidirectional unipolar element D11 coupled between the source of the input transistor T11 and the supply terminal V1, the first further current mirror (T13, T14) comprising a unipolar transistor T13 having a gate, having a drain coupled both to the gate of the transistor T13 and to a first input terminal 11 coupled to the drain of the output transistor T12, and having a source coupled to a first emitter terminal 12 coupled to a second supply terminal V2, and a unipolar transistor T14 having a gate coupled to the gate of the transistor T13, having a drain coupled to a first ourtput terminal 13 coupled to the drain of the input transistor T11, and having a source coupled to the emitter terminal 12 coupled to the supply terminal V2. The second non-linear currrent mirror (T21, T22, D21, D22) comprises a second unipolar input trnaistsor T21 having a gate, having a drain coupled to the gate of the input transistor T21, and having a source, a second unipolar output transistor T22 having a gate coupled to the gate of the input transistor T21, having a drain, and having a source, a first unidirectional bipolar element D21 coupled between the source of the input transistor T21 and a third supply terminal V3, and a second unidirectional bipolar element D22 coupled between the source of the output transistor T22 and the supply terminal V3, the second further current mirror (T23, T24) comprising a unipolar transistor T23 having a gate, having a drain coupled both to the gate of the transistor T23 and to a seecond input terminal coupled to the drian of the output transistor T22, and having a source coupled to a a second emitter terminal 22 coupled to a fourth supply terminal V4, and a unipolar transistor T24 having a gate coupled to the gate of the transistor T23, having a drain coupled to an output terminal 23 coupled to the drain of the input transistor T21, and having a source coupled to the emitter terminal 22 coupled to the supply terminal V4. The third means M3 has a third input terminal 31 coupled to the input terminal 11, a fourth input terminal 32 coupled to the input terminal 21, and a reference terminal 33 for supplying the reference current Iref with the specific temperature coefficient, as well as a unipolar transistor T31 having a gate coupled to the input terminal 31, having a drain coupled to the reference terminal 33, and having a source coupled to the emitter terminal 12 coupled to the supply terminal V2, and a unipolar transistor T32 having a gate coupled to the input terminal 32, having a drain coupled to the reference terminal 33, and having a source coupled to the emitter terminal 22 coupled to the supply terminal V4. In the present embodiment the supply terminals V1 and V3 are coupled to one another and the supply terminals V2 and V4 are coupled to one another. The reference circuit constructed as described above operates as described hereinafter.

When the first means M1 are energized a voltage which is inversely proportional to the temperature appears between the gate of the input transistor T11 and the supply terminal V1, which voltage is equal to at least two threshold voltages. Since the output transistor T12 is driven with the voltage which is inversely proportional to the temperature a current with a negative temperature coefficient will flow through the output transistor T12 and, consequently, through the transistor T13, the transistor T14, the input transistor T11 and the unidirectional element D11. When the second means M2 are energized a voltage proportional to the temperature appears between the sources of the inout transistor T21 and the output transistor T22, which voltage in combination with a voltage appearing between the gate and the source of the input transistor T21 results in a further voltage which is proportional to the temperature. Since the output transistor T22 is driven with the further voltage which is proportional to the temperature a current with a positive temperature coefficient will flow through the output transistor T22 and, consequently, through the transistor T23, the transistor T24, the input transistor T21, the unidirectional element D21, and the unidirectional element D22.

When the first means M1 and the second means M2 are energized the third means M3 are also energized, the input transistor T31 carrying a reference current Iref1 related to the current with the negative temperature coefficient and the input transistor T32 carrying a reference current Iref2 related to the current with the positive temperature coefficient. Since the input transistors T31 and T32 both have their drains coupled to the reference terminal 33 the two reference currents Iref1 and Iref2 are combined to form the reference current Iref having the predetermined temperature coefficient, the predetermined temperature coefficient being determined indirectly by the reference currents Iref1 and Iref2 and directly by the relevant circuit parameters. With respect to the circuit parameters it is to be noted that in particular the source areas of the transistors in the various current mirrors, the area of the unidirectional element D11, and the ratio between the areas of the unidirectional elements D21 and D22 are relevant. The predetermined temperature coefficient can be given a negative value, a value of zero or a positive value depending on the circuit parameters.

The invention is not limited to the embodiment shown herein. Within the scope of the invention several modifications are conceivable to those skilled in the art. Thus, the first means, the second means and the third means can be constructed in various other ways than in the embodiment shown. A first possibility, for example, is that the current mirrors used are replaced by improved current mirrors. A second possibility is that the further current mirrors are replaced by non-linear current mirrors, in which case for example the first further current mirror and the first non-linear current mirror on the one hand and the second further current mirror and the second non-linear current mirror on the other hand are constructed in a similar way but with transistors of an opposite conductivity type. A further possibility is, for example, to construct the third means in another way than in the embodiment shown.

## Claims

1. A reference circuit for supplying a reference current with a predetermined temperature coefficient, which circuit comprises first means for generating a first reference current with a negative temperature coefficient, second means for generating a second reference current with a positive temperature coefficient, and third means for generating the reference current with the predetermined temperature coefficient on the basis of the first and the second reference current, characterised in that the first means include a first non-linear current mirror comprising at least a first unipolar input transistor having a gate, having a drain coupled to the gate of the first unipoilar input transistor, and having a source, a first unipolar output transistor having a gate coupled to the gate of the first unipolar input transistor, having a drain, and having a source coupled to a first supply terminal, and a unidirectional unipolar element coupled between the source of the first unipolar input transistor and the first supply terminal, and a first further current mirror having at least a first input terminal coupled to the drain of the first unipolar output transistor, having a first output terminal coupled to the drain of the first unipolar input transistor, and having a first emitter terminal coupled to a second supply terminal, in that the second means include a second non-linear currrent mirror comprising at least a second unipolar input transistor having a gate, having a drain coupled to the gate of the second unipolar input transistor, and having a source, a second unipolar output transistor having a gate coupled to the gate of the second unipolar input transistor, having a drain, and having a source, a first unidirectional bipolar element coupled between the source of the second unipolar input transistor and a third supply terminal, and a second unidirectional bipolar element coupled between the source of the second unipolar output transistor and the third supply terminal, and a second further current mirror comprising at least a second input terminal coupled to the drain of the second unipolar output transistor, a second output terminal coupled to the drain of the second unipolar input transistor, and a second emitter terminal coupled to a fourth supply terminal, and in that the third means have a third input terminal coupled to the first input terminal, a fourth input terminal coupled to the second input terminal, and a reference terminal for supplying the reference current with the predetermined temperature coefficient.

2. A reference circuit as claimed in Claim 1, characterised in that the third means further include a third input transistor having a gate coupled to the third input terminal, having a drain coupled to the reference terminal, and having a source coupled to the second supply terminal, and a fourth input transistor having a gate coupled to the fourth input terminal, having a drain coupled to the reference terminal, and having a source coupled to the fourth supply terminal.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| P,A | EP-A-0 424 264 (SGS-THOMSON MICROELECTRONICS)<br>* page 4, line 3 - page 5, line 31; figures 3,4 *<br>--- | 1,2 | G05F3/24<br>H03F1/30 |
| A | US-A-4 994 729 (STEWART S. TAYLOR)<br>* column 2, line 13 - line 38 *<br>* column 2, line 53 - column 3, line 42 *<br>* column 6, line 25 - line 42 *<br>* figure 2 *<br>--- | 1 | |
| A | EP-A-0 219 994 (AMERICAN MICROSYSTEMS)<br>* column 10, line 24 - line 32; figure 1 *<br><br>----- | 1 | |

TECHNICAL FIELDS
SEARCHED (Int. Cl.5)

G05F
H03F

The present search report has been drawn up for all claims

| Place of search | Date of completion of the search | Examiner |
|---|---|---|
| THE HAGUE | 30 JUNE 1992 | WALDORFF U. |

EPO FORM 1503 03.82 (P0401)